# EUROPÄISCHE PATENTSCHRIFT

(11) **EP 2 686 890 B1**
(45) Veröffentlichungstag und Bekanntmachung des Hinweises auf die Patenterteilung: **06.05.2015**
(21) Anmeldenummer: 12701718.4
(22) Anmeldetag: 23.01.2012
(51) Int. Cl.: H01L 31/05

(54) **VERFAHREN ZUR HERSTELLUNG EINER SOLARZELLENANORDNUNG**
METHOD FOR PRODUCING A SOLAR CELL ARRAY
PROCÉDÉ DE FABRICATION D'UN ENSEMBLE DE CELLULES SOLAIRES

(30) Priorität: 15.03.2011 DE 102011005560
(43) Veröffentlichungstag der Anmeldung: 22.01.2014
(73) Patentinhaber: SolarWorld Industries Thüringen GmbH, 99310 Arnstadt (DE)
(72) Erfinder: FUNK, Karsten, 99425 Weimar (DE); ZERRER, Patrick, 99092 Erfurt (DE); GROHE, Andreas, 10437 Berlin (DE)
(74) Vertreter: Isarpatent
(86) Internationale Anmeldenummer: PCT/EP2012/050932
(87) Internationale Veröffentlichungsnummer: WO 2012/123148

(56) Entgegenhaltungen:
- EP-A2- 1 205 982
- WO-A1-2006/137746
- US-A- 3 574 925
- US-A1- 2010 108 123
- US-A1- 2011 005 568

## Beschreibung

Die Erfindung betrifft ein Verfahren zur Herstellung einer Solarzellenanordnung aus einer Mehrzahl von mittels Zellenverbinder-Bändern zu Strings verbundenen Solarzellen, wobei die Zellenverbinder-Bänder eine zur Verbesserung des Lichteinfalls auf die Nutzfläche der Solarzellen strukturierte Oberfläche aufweisen.

### Stand der Technik

Aus dem Stand der Technik bekannte Photovoltaik-Module auf der Basis von Halbleitern bestehen aus einer Gesamtheit von Halbleiterzellen (Solarzellen). In diesen wird unter der Wirkung eines äußeren Lichteinfalls eine elektrische Spannung erzeugt. Die Halbleiterzellen sind zweckmäßig miteinander verschaltet, um von dem Photovoltaik-Modul technisch brauchbare Spannungen und Stromstärken abgreifen zu können. Damit sind eine Kontaktierung der Halbleiterzellen und eine zweckmäßige Leitungsführung innerhalb des Photovoltaik-Moduls notwendig.

Bei bekannten Photovoltaik-Modulen werden zur Verbindung der Solarzellen Zellenverbinder-Bänder verwendet. Dabei handelt es sich in der Regel um in Rollenform gelieferte und im Montageprozess geeignet abgelängte Profile aus einem gut leitfähigen Metall, insbesondere Kupfer. Die Kontaktierung zwischen einem Zellenverbinder-Band und den damit verschalteten Halbleiterzellen erfolgt üblicherweise mittels einer Weichlotverbindung. Dabei sind die Kontakte von einer oberen lichtaktiven Seite einer Halbleiterzelle auf eine lichtabgewandte rückwärtige Seite einer nächsten Halbleiterzelle geführt. An den Kontaktstellen zwischen dem Zellenverbinder-Band und der Halbleiterzelle befinden sich auf den Halbleiterzellen metallisierte Kontaktbereiche, auf denen die Lotverbindung vorgenommen wird. Ein Solarmodul-Aufbau dieser Art ist beispielsweise in der US 2009/ 0056784 A1 beschrieben.

Auf denjenigen Solarzelien des Moduls, auf denen die Zellenverbinder-Bänder (auch bezeichnet als Zelltabs-, Ribbons oder Soldersleeves) auf der lichtzugewandten Seite verlaufen, geht aktive Zellenfläche verloren. Es gibt daher neuerdings speziell profilierte Leitungsverbinder-Bänder, die als Light-Harvesting-Strings (LHS), Light-Capturing-Ribbens oder auch Light-Capturing-Strings (LCS) bezeichnet werden. Deren eine Oberfläche ist derart strukturiert, dass senkrecht einfallendes Licht unter einem bestimmten Winkel zur Flächennormale reflektiert wird und letztlich nach Totalreflexion an der Grenzfläche zwischen dem Glasträger und der Atmosphäre oder mehrfachen Reflextionen ein erheblicher Anteil auf die aktive Zellenfläche gelangt und dort photovoltaisch wirksam wird. Derartige Zellenverbinder-Bänder sind handelsüblich.

Nach aktuellem Stand der Technik sind Zellenverbinder-Bänder vom LHS- bzw. LCS-Typ einseitig lötbar ausgestattet und werden auf der anderen (strukturierten) Oberfläche durch Auftrag von Lötpaste oder selektive Vorverzinnung (mit Lot) lötbar gemacht. Bei ihrem Einsatz in der Serienproduktion haben sich vielfältige Probleme ergeben. Nach derzeitigem Stand der Entwicklung muss ihr Einsatz durch ingenieurtechnisches Personal laufend überwacht werden, und eine Automatisierung des Modul-Montageprozesses mit solchen Bändern hat sich als schwierig erwiesen.

Die gattungsgemäße US 2010/108123 A1 beschreibt ein Verbindungsreflektorband für Solarzellenmodule. Hier ist ein Verfahren zur Herstellung einer Solarzellenanordnung aus einer Mehrzahl von mittels Zellenverbinder-Bändern zu Strings verbundenen Solarzellen offenbart, bei dem die Zellenverbinderbänder eine zur Verbesserung des Lichteinfalls auf die Nutzfläche der Solarzellen strukturierte Oberfläche aufweisen.

Weiterhin sind in diesem Zusammenhang auch die US 2011/005568 A1, WO 2006/137746 A1 und EP 1 205 982 A2 zu nennen.

### Offenbarung der Erfindung

Es wird ein Verfahren zur Herstellung einer Solarzellenanordnung mit den Merkmalen des Anspruches 1 oder den Merkmalen des Anspruches 4 vorgeschlagen. Zweckmäßige Fortbildungen des Erfindungsgedankens sind Gegenstand der jeweiligen abhängigen Ansprüche.

Gemäß einem ersten Aspekt der Erfindung wird die strukturierte Oberfläche der Zellenverbinder-Bänder vom LHS- bzw. LCS-Typ selektiv nur in vorbestimmten Abschnitten lötbar gemacht, und zwar unmittelbar im Prozess des Verbindens der Solarzellen zur Gesamtanordnung, also speziell der Montage eines Solarzellenmoduls.

In einer zweckmäßigen Ausgestaltung ist vorgesehen, dass die strukturierte Oberfläche nur in vorbestimmten Abschnitten mit einem Lötpulver beschichtet und das Zellenverbinder-Band in diesen Abschnitten mit einer Rückseite einer Solarzelle verlötet wird. Aus anlagentechnischer Sicht ist insbesondere vorgesehen, dass die im Ausgangszustand unbeschichtete strukturierte Oberfläche innerhalb eines zum Verbinden der Solarzellen eingesetzten Lötautomaten bzw. einer Löt-Linie selektiv lokal lötbar gemacht wird.

Gemäß einem relativ unabhängigen zweiten Aspekt der Erfindung wird in einem Pulversprühschritt unmittelbar im Montageprozess das jeweilige Zellenverbinder-Band unter Auftrag eines geeigneten Pulvers auf den entsprechenden Bandabschnitt direkt auf eine Solarzellen-Rückseite aufgebunden.

In einer Ausführung der Erfindung wird die Beschichtung mit Lötpulver bzw. das unmittelbare Aufbinden auf die Solarzellen-Rückseite unter Pulver-Einsatz mittels eines Plasmasprühverfahrens ausgeführt. Alternativ hierzu können die Techniken des Kaltgasspritzens oder des thermischen Spritzens eingesetzt werden. All diese Techniken der Pulververarbeitung sind dem Fachmann vertraut und werden daher hier nicht im Einzelnen beschrieben.

Gegenüber der derzeit praktizierten Technologie mit Lötpasten hat das vorgeschlagene Verfahren eine Reihe von Vorteilen.

Es kann auf den Auftrag von Lötpaste verzichtet werden. Dadurch kann der Zellbruch in der Verarbeitung verringert werden. Die Prozessstabilität kann erhöht werden. Die Gefahr, die durch zusätzliche Bestandteile in der Lötpaste auf die Modulzuverlässigkeit wirkt, kann vermieden werden.

Handhabungsfehler durch einen Operator können vermieden werden. Toleranzen bei der LHS-Herstellung können nicht zum Versatz des lötbaren Bereichs während des sog. Stringens führen. Es gibt keinen Verschnitt, d. h. Abfall wies reduziert. Der LHS kann ca. 10 % günstiger beschafft werden, wenn an die strukturierte Oberfläche außer den Light-Trapping-Eigenschaften keine weiteren Anforderungen gestellt werden.

### Zeichnungen

Das erfindungsgemäße Verfahren und die erfindungsgemäßen Photovoltaik-Module sollen nachfolgend anhand von Ausführungsbeispielen näher erläutert werden. Es ist zu beachten, dass die Zeichnungen nur beschreibenden Charakter haben und nicht dazu gedacht sind, die Erfindung in irgendeiner Form einzuschränken. Es zeigen:
- Fig. 1: eine schematische Darstellung zur Illustration einer ersten Ausführungsform des erfindungsgemäßen Verfahrens und
- Fig. 2: eine schematische Darstellung zur Illustration einer zweiten Ausführungsform des erfindungsgemäßen Verfahrens.

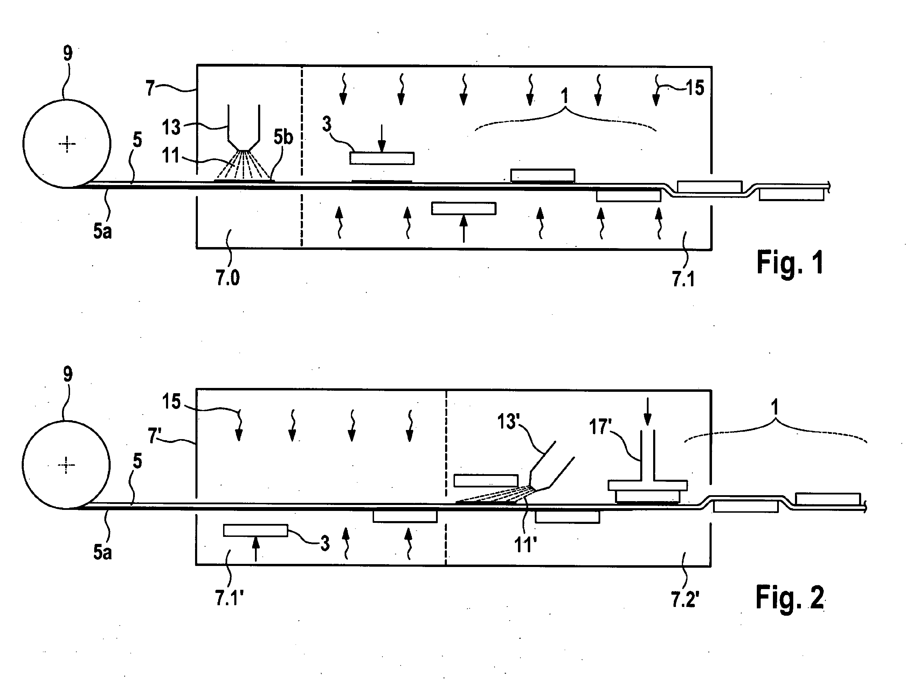

Fig. 1 zeigt schematisch wesentliche Aspekte eines Prozessablaufs zum Verbinden von Solarzellen **1** zu einem Solarmodul **3** mittels eines Zellenverbinder-Bandes **5** vom LHS-Typ in einem Lötautomaten **7.** Das Zellenverbinder-Band **5** wird mit einseitiger lötfähiger Beschichtung **5a** auf einer Rolle **9** geliefert und von dieser dem Lötautomaten **7** zugeführt.

In einem der eigentlichen Lötstrecke **7.1** vorgeschalteten Beschichtungsabschnitt **7.0** wird auf die unbeschichtet gelieferte, strukturierte zweite Oberfläche des Zellenverbinder-Bandes nur in vorbestimmten Abschnitten der Längserstreckung durch Aufsprühen eines Lötpulvers **11** selektiv eine zweite lötfähige Beschichtung **5b** aufgebracht. Dies geschieht durch eine hier symbolisch gezeigte Sprühvorrichtung **13,** die vorteilhafterweise als Plasmasprühvorrichtung ausgeführt sein kann. In der Lötstrecke **7.1** des Lötautomaten **7** wird unter Wärmeeinwirkung das Zellenverbinder-Band **5** mit seiner vorgefertigten ersten Beschichtung **5a** auf die Oberseite einer ersten Zelle aufgelötet und über seine direkt im Prozessablauf aufgebrachte zweite Beschichtung **5b** auf die Unterseite der benachbart angeordneten Zelle **11** aufgelötet. Es folgen übliche Schritte der Solarmodul-Fertigung, wie das Einlaminieren in EVA-Folie, das Anordnen auf einem Modul-Träger und die Anbringung einer Anschlussdose, die hier nicht dargestellt sind.

Das in Fig. 2 dargestellte Verfahren ähnelt demjenigen nach Fig. 1, so dass für gleiche bzw. zueinander korrespondierende Teile bzw. Abschnitte die gleichen Bezugsziffern, die in Fig. 1 gewählt wurden und diese Teile bzw. Abschnitte hier nicht nochmals beschrieben werden. Der wesentliche Unterschied zum oben beschriebenen Verfahren besteht darin, dass ein modifizierter Lötautomat **7'** eingesetzt wird, der neben einer herkömmlichen (gegenüber der Ausführung nach Fig. 1 aber verkürzten) Lötstrecke **7.1'** einen Pulvertechnik-Verbindungsabschnitt **7.2'** aufweist.

Bei diesem Verfahren gelangt das zugelieferte Zellenverbinder-Band **5** mit einseitiger Beschichtung **5a** ohne weitere Vorbehandlung in die Lötstrecke **7.1'** und wird dort mit der Oberseite jeder zweiten Zelle **1** verlötet. Eine Verbindung zwischen dem Zellenverbinder-Band **5** und den jeweils benachbarten Zellen, die auf deren Unterseite und somit über die profilierte Oberseite des Zellenverbinder-Bandes herzustellen ist, erfolgt im Pulvertechnik-Verbindungsabschnitt **7.2'.** Dort befinden sich eine (hier ebenfalls nur symbolisch dargestellte) Pulversprühvorrichtung **13'** zum lokalen Einbringen eines Verbindungs-Pulvers **11'** zwischen der Oberfläche der jeweiligen Solarzelle und die ihr zugewandte Oberfläche des Zellenverbinder-Bandes **5** sowie ein beheizter Druckstempel **15'** zum Andrücken des Zellenverbinder-Bandes an die Zellenoberfläche zur Herstellung einer stoffschlüssigen und elektrisch leitfähigen Verbindung. Das Einbringen des Verbindungspulvers **11'** kann hier beispielsweise mittels Kaltgasspritzen oder thermischen Spritzen oder mittels eines anderen bekannten Verfahrens des Pulverauftrags erfolgen. Das Herstellen der stoffschlüssigen Verbindung kann auch durch kontaktloses Löten mittels z. B. IR oder Induktion erfolgen.

Im Übrigen ist die Ausführung der Erfindung nicht auf die vorstehend erläuterten Beispiele und hervorgehobenen Aspekte beschränkt, sondern ebenso in einer Vielzahl von Abwandlungen möglich, die im Rahmen fachgemäßen Handelns liegen.

## Patentansprüche

1. Verfahren zur Herstellung einer Solarzellenanordnung (3) aus einer Mehrzahl von mittels Zellenverbinder-Bändern (5) zu Strings verbundenen Solarzellen (1), wobei die Zellenverbinder Bänder eine zur Verbesserung des Lichteinfalls auf die Nutzfläche der Solarzellen strukturierte Oberfläche aufweisen,
**dadurch gekennzeichnet, dass** die strukturierte Oberfläche im Prozess des Verbindens der Solarzellen selektiv lötbar gemacht wird.

2. Verfahren nach Anspruch 1,
wobei die strukturierte Oberfläche nur in vorbestimmten Abschnitten mit einem Lötpulver beschichtet und das Zellenverbinder-Band (5) in diesen Abschnitten mit einer Rückseite einer Solarzelle (1) verlötet wird.

3. Verfahren nach Anspruch 1 oder 2,
wobei die im Ausgangszustand unbeschichtete strukturierte Oberfläche innerhalb eines zum Verbinden der Solarzellen eingesetzten Lötautomaten (7) bzw. einer Löt-Linie selektiv lokal lötbar gemacht wird.

4. Verfahren zur Herstellung einer Solarzellenanordnung (3) aus einer Mehrzahl von mittels Zellenverbinder-Bändern (5) zu Strings verbundenen Solarzellen (1), wobei die Zellenverbinder-Bänder eine zur Verbesserung des Lichteinfalls auf die Nutzfläche der Solarzellen strukturierte Oberfläche aufweisen,
**dadurch gekennzeichnet, dass** die strukturierte Oberfläche in Abschnitten, in denen das Zellenverbinder-Band mit einer Rückseite einer Solarzelle zu verbinden ist, in einem Pulversprühschritt direkt auf die Solarzellen-Rückseite aufgebunden wird.

5. Verfahren nach einem der Ansprüche 2 bis 4,
wobei die Beschichtung bzw. das Aufbinden auf die Solarzellen-Rückseite mittels Plasmasprühen ausgeführt wird.

6. Verfahren nach einem der Ansprüche 2 bis 4,
wobei die Beschichtung bzw. das Aufbinden auf die Solarzellen-Rückseite mittel Kaltgasspritzen ausgeführt wird.

7. Verfahren nach einem der Ansprüche 2 bis 4,
wobei die Beschichtung bzw. das Aufbinden auf die Solarzellen-Rückseite mittels thermischen Spritzens ausgeführt wird.

## Claims

1. Method for manufacturing a solar cell arrangement (3) from a plurality of solar cells (1) which are connected into strings by means of cell connector bands (5), the cell connector bands comprising a surface which is structured so as to improve the incidence of light on the useful area of the solar cells,
**characterised in that** the structured surface is selectively made solderable in the process of connecting the solar cells.

2. Method according to claim 1,
wherein the structured surface is coated with a soldering powder merely in predetermined portions and the cell connector strip (5) is soldered to a rear face of a solar cell (1) in these portions.

3. Method according to either claim 1 or claim 2,
wherein the structured surface, which is initially uncoated, is selectively made solderable locally within a soldering machine (7) used for connecting the solar cells or within a soldering line.

4. Method for manufacturing a solar cell arrangement (3) from a plurality of solar cells (1) which are connected into strings by means of cell connector bands (5), the cell connector bands comprising a surface which is structured so as to improve the incidence of light on the useful area of the solar cells,
**characterised in that**, in portions in which the cell connector band is to be connected to a rear face of a solar cell, the structured surface is bonded directly onto the solar cell rear face in a powder spraying step.

5. Method according to any of claims 2 to 4,
wherein the coating or the bonding onto the solar cell rear face is carried out by plasma spraying.

6. Method according to any of claims 2 to 4,
wherein the coating or bonding onto the solar cell rear face is carried out by cold gas spraying.

7. Method according to any of claims 2 to 4,
wherein the coating or bonding onto the solar cell rear face is carried out by thermal spraying.

## Revendications

1. Procédé de fabrication d'un ensemble de cellules solaires (3) à partir d'une pluralité de cellules solaires (1) reliées à l'aide de bandes de liaison de cellules (5) pour former des séries, les bandes de liaison de cellules présentant une surface structurée destinée à améliorer l'incidence de la lumière sur la surface utile des cellules solaires, ,
**caractérisé en ce que** la surface structurée est rendue sélectivement brasable lors du processus de liaison des cellules solaires.

2. Procédé selon la revendication 1,
dans lequel la surface structurée n'est recouverte d'une poudre de brasage que dans des segments prédéterminés et la bande de liaison de cellules (5) est brasée dans ces segments avec une face arrière d'une cellule solaire (1).

3. Procédé selon la revendication 1 ou 2,
dans lequel la surface structurée non recouverte dans l'état initial est rendue sélectivement brasable localement au sein d'un automate de brasage (7), respectivement d'une ligne de brasage, utilisé(e) pour relier les cellules solaires.

4. Procédé de fabrication d'un ensemble de cellules solaires (3) à partir d'une pluralité de cellules solaires (1) reliées à l'aide de bandes de liaison de cellules (5) pour former des séries, les bandes de liaison de cellules présentant une surface structurée destinée à améliorer l'incidence de la lumière sur la surface utile des cellules solaires,
**caractérisé en ce que** la surface structurée est, lors d'une étape de pulvérisation de poudre, liée directement sur la face arrière des cellules solaires dans les segments où la bande de liaison de cellules doit être reliée à une face arrière d'une cellule solaire.

5. Procédé selon une des revendications 2 à 4,
dans lequel le revêtement, respectivement la liaison, sur la face arrière des cellules solaires est réalisé au moyen d'une pulvérisation par plasma.

6. Procédé selon une des revendications 2 à 4,
dans lequel le revêtement, respectivement la liaison, sur la face arrière des cellules solaires est réalisé au moyen d'une projection par gaz froid.

7. Procédé selon une des revendications 2 à 4,
dans lequel le revêtement, respectivement la liaison, sur la face arrière des cellules solaires est réalisé au moyen d'une projection thermique.
